(19) Europäisches Patentamt
European Patent Office
Office européen des brevets

(11) **EP 4 145 144 A1**

(12) **EUROPEAN PATENT APPLICATION**

(43) Date of publication:
**08.03.2023 Bulletin 2023/10**

(21) Application number: **21194972.2**

(22) Date of filing: **06.09.2021**

(51) International Patent Classification (IPC):
**G01R 23/16** $^{(2006.01)}$ **H04L 1/00** $^{(2006.01)}$
**H04L 27/00** $^{(2006.01)}$

(52) Cooperative Patent Classification (CPC):
**G01R 23/16; H04L 1/0003; H04L 27/0006;
H04L 27/0012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Rockwell Collins, Inc.
Cedar Rapids, IA 52498 (US)**

(72) Inventors:
• **GARCIA GENER, Alejandro
Cork, T23NW88 (IE)**
• **PALOP, Hector
Cork (IE)**
• **PHAM, Thu Le Thi Anh
Cork (IE)**

(74) Representative: **Dehns
St. Bride's House
10 Salisbury Square
London EC4Y 8JD (GB)**

(54) **SPECTRUM ANALYSIS FOR DYNAMIC SPECTRUM ACCESS**

(57) A method of analysing a spectrum on which information is transmitted, comprising: determining each different type of modulation used for transmitting the information across the spectrum, for each determined modulation, identifying its carrier frequency and its bandwidth, defining characteristics of usage of the spectrum in terms of the determined modulations and their corresponding carrier frequencies and bandwidths.

FIG. 1

**Description**

TECHNICAL FIELD

The present disclosure is concerned with spectrum analysis to enable improved dynamic spectrum access (DSA) to monitor communication on, and to make effective use of, available bandwidth.

BACKGROUND

With the introduction of new technologies and the increased requirement for communication between users, devices and technologies, spectral bandwidth is becoming scarce and its use has to be optimised and improved to ensure continuous communication demands are met. This is particularly important in safety-critical systems such as in the aerospace field, where the quality of communications must be guaranteed. This includes signals from the multiple sensors used in aircraft control and maintenance, actuator command signals, navigation instructions from the control tower etc. Whilst development is focussing on increasing bandwidth through e.g. 4G, 5G technologies and the like, there is also focus on making the best use of available bandwidth by analysing how that bandwidth is used and providing dynamic spectrum access (DAS) solutions where 'spaces' exist.

In addition, there may be the need, e.g. in military applications, to obtain information about existing communications in unknown environments.

While DSA solutions are known e.g. from H. Song, L. Liu, J. Ashdown and Y. Yi, 'A Deep Reinforcement Learning Framework for Spectrum Management in Dynamic Spectrum Access,' IEEE Internet of Things Journal, doi: 10.1109/JIOT.2021.3052691, Y. Xu, J. Yu, W.C. Headley and R.M. Buehrer, 'Deep Reinforcement Learning for Dynamic Spectrum Access in Wireless Networks,' MILCOM 2018 - 2018 IEEE Military Communications Conference, (MILCOM), Los Angeles, CA, USA, 2018, pp. 207-212, doi: 10.1109/MILCO and O. Naparstek and K. Cohen, 'Deep Multi-User Reinforcement Learning for Distributed Dynamic Spectrum Access,' IEEE Transactions on Wireless Communications, vol. 18, no. 1, pp. 310 - 323, Jan. 2019, doi: 10.1109/TWC.2018.2879433, these rely on predetermined communication channels and identifying which of those channels are currently available, and allowing communication on those. Conventionally, when a user wishes to communicate on a network, the user has to request access and obtain a response from the network, whereby the user is allocated a fixed bandwidth channel and time slot on which they may communicate. Such allocation is not particularly efficient and may not actually make use of available bandwidth in view of the fluctuating nature of the spectrum. Alternative solutions, such as described in G. Hong, J. Martin and J. Westall, 'Adaptive bandwidth binning for bandwidth management,' Elsevier, 2019, use a technique known as data binning, where metadata is obtained from the data packet to be transmitted, and the data is placed on the communication bus by means of a scheduler.

More recently, the evolution of embedded machine learning has allowed the development of new techniques for spectrum analysis and DSA. Many of these systems, however, also rely on detecting non-busy, predetermined channels to which access is provided. Other solutions to obtaining access by analysing the spectrum, such as H. Chang, H. Song, Y. Yi, J. Zhang, H. He and L. Liu, 'Distributive Dynamic Spectrum Access Through Deep Reinforcement Learning: A Reservoir Computing-Based Approach,' IEEE Internet of Things Journal, vol. 6, no. 2, pp. 1938 - 1948, April 2019, doi: 10.1 are known. Whilst such methodologies provide an effective DSA solution, the fully automated nature, and the use of Recurrent Neural Networks (RNN), means that the information obtained from the analysis and the way in which it is used to make access decisions is not in a human-readable form and is not transparent. Some industries, e.g. the aerospace industry, require, for safety, that data used in such access decisions is available to be read and understood by humans. Certification of communications systems often relies on such information being made available during the process. RNNs also require high computational power which makes them difficult to integrate into some devices or systems.

There is, therefore a need for a technique for analysing the spectrum to allow for effective DSA and/or for obtaining information about the communication environment in a manner that the information used in the technique can be interpreted by humans.

SUMMARY

According to the disclosure, there is provided a method of analysing a spectrum on which information is transmitted, comprising: determining each different type of modulation used for transmitting the information across the spectrum, for each determined modulation, identifying its carrier frequency and its bandwidth, defining characteristics of usage of the spectrum in terms of the determined modulations and their corresponding carrier frequencies and bandwidths.

Also provided is a system for analysing a spectrum on which information is transmitted, the system including a first module configured to determine the number of modulations used to transmit information on the spectrum, a second module configured to determine the carrier frequency of each modulation determined by the first module, a third module configured to determine the bandwidth of each modulation determined by the second module, and a fourth module to provide a spectrum characterisation in terms of the number of modulations and their carrier frequencies and bandwidths

BRIEF DESCRIPTION

Examples of techniques according to the disclosure will now be described by way of example only. The scope of the invention is not limited by the description and variations are possible within the scope of the invention as defined by the claims.

Figure 1 shows the architecture of a system according to the disclosure.

Figure 2 shows an example of a simple decision tree for use in techniques according to the disclosure.

Figure 3 shows, in more detail, features of spectrum characterisation according to the disclosure.

Figure 4 shows features of spectrum characterisation adapted for the microwave frequency range.

Figure 5 shows a training configuration used in signal allocation according to an example of a technique according to the disclosure.

Figure 6 shows details of an example signal allocation implantation for an example of the technique according to the disclosure.

DETAILED DESCRIPTION

The spectrum analysis technique of the present disclosure is configured to recurrently capture useful information from the communications network spectrum and provide this as interpretable, human-readable data from which useful data can be extracted e.g. to identify characteristics of an unknown network and/or for use in dynamic spectrum allocation - allocating space on a spectrum to a user wishing to communicate on the network. The provision of intermediate data which can be read/interpreted by a human means that the technique can be used in systems such as avionics, the certification of which relies on being understandable to humans.

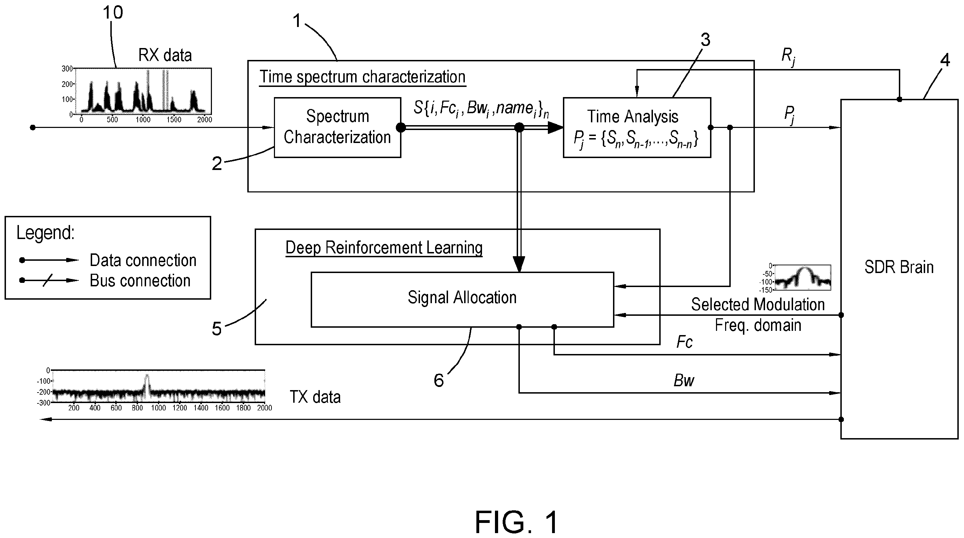

With reference to Fig. 1, the spectrum 10 is subjected to a time spectrum characterisation 1. This is a two-part analysis. The spectrum first undergoes a spectrum characterisation 2 which identifies attributes of the frequency profiles found in the spectrum 10. The spectrum characterisation feature 2 determines the number of modulations ($i$) appearing in the spectrum 10, the type of those modulations ($name_i$), the carrier frequency ($Fc_i$) and bandwidth ($Bw_i$) of each modulation and of unintended (e.g. noise) signals such that each frequency sample $(Frx_h)_n$, where $n$ is a specific sample in time, is defined by a specific set of characteristics in readable form:

$$(Frx_h)_n = S\{ I, Fc_i, Bw_i, name_i\}_n$$

These characteristics can then be fed into a time analysis block 3 to obtain a time analysis using a stream reasoning engine as described further below, to detect specific patterns ($P_j$) in time, defined as a set of rules ($R_j$), such as frequency jumps over time or a particular periodicity, which can be used for the allocation of parts of the spectrum for signals to be communicated on the network, as described further below.

In one example, as shown, the detected patterns ($P_j$) are provided to a processor (here described as the SDR Brain) 4. The Brain 4 determines, based on the time analysis, the proper modulation to use for communication of the next piece of information to be transmitted. In addition, the SDR brain 4 may update the rules set ($R_j$) used by the time analysis block 3 based on a determination of which patterns are relevant to be recognized, based on the spectrum characteristics.

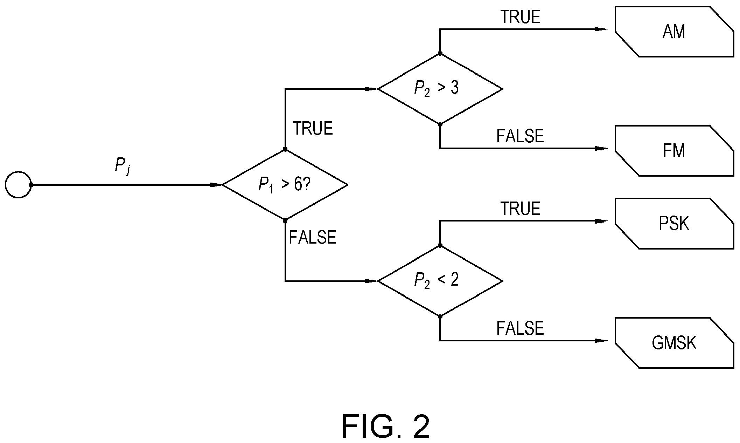

The brain 4 may select the appropriate modulation to use for the information to be transmitted in various ways. One example is by using a decision tree such as shown in Fig. 2. In the example shown, The set rules are that the modulation is QPSK modulation ($R_1$) and that the carrier frequency is between $t_1$ and $t_2$. The first decision, in this example, is whether the number of QPSK modulations ($P_1$) is greater than 6. If so, it is determined whether the number of modulations that are stable over time over the same carrier frequency ($P_2$) exceeds 3. If so, amplitude modulation, AM, is selected. If not, frequency modulation, FM, is selected. If the number of QPSK modulations ($P_1$) is not greater than 6, it is determined whether the number of modulations that are stable over time over the same carrier frequency ($P_2$) is less than 2. If so, phase shift keying, PSK, is the selected modulation. If not, Gaussian minimum shift keying, GMSK, is selected.

This is, of course, one example only of the methodology that could be used for selecting the appropriate modulation, even if a similar decision tree is used, the rules and patterns are selected according to the application in question.

In the example shown, once the spectrum has been analysed, and the modulation type has been selected, the signal characteristics, the patterns from the time analysis and the selected modulation can be fed to a deep reinforcement learning (RL) block 5 with a signal allocation algorithm 6 which can determine the carrier frequency and bandwidth of the modulated signal. Using the determined carrier frequency $Fc$ and bandwidth $Bw$, the SDR brain 4 allocates a part of the spectrum to the signal to be transmitted and introduces the signal to the spectrum at the best carrier frequency and bandwidth available.

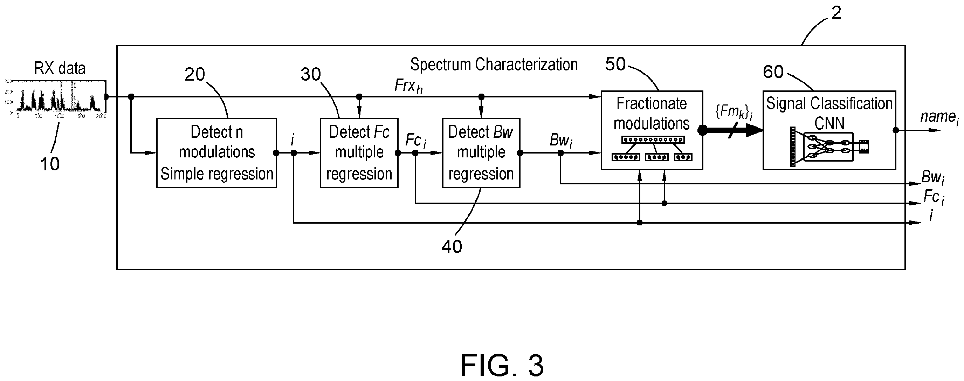

With reference to Fig. 3, the spectrum characterisation block 2 will now be described, for one example, in more detail.

As described above, this block 2 identifies the number of modulations $i$ present in a spectrum being observed, identifying their carrier frequency $Fc_i$ and band-

width $Bw_i$ to determine their location in the spectrum, and classifying them ($name_i$) into a set of predetermined classes. Fig.3 shows possible blocks for deriving the characteristics.

One way of identifying or predicting the number of modulations $i$ involves providing the frequency representation 10' of the spectrum to be analysed to a machine learning based model. A simple regression calculation can be performed (block 20) preferably using any known type of predictor that is able to identify gradients in data, e.g, a one-dimensional CNN, a Gaussian Process, or an XGBoost regressor, although other simpler models e.g. polynomial regression or a Gaussian k Nearest Neighbours algorithm could also be used.

Next (block 30), the carrier frequency ($Fc_i$) is determined for each modulation. This may be done using similar predictors but multivariate regression is required because outputs need to be predicted for the multiple number of modulations i from the first block 20.

A similar procedure is then performed at block 40 to determine the spectral bandwidth $Bw$ for each modulation.

In one example, each regressor block may be trained separately, to avoid errors being propagated through the system.

These processes result in the incoming signal being fragmented into the different modulations defined by their position and width in the spectrum, stored at block 50.

While this provides extensive information as to the information populating the spectrum, the information can be further augmented by specifying the type of signals the identified modulations consist of, in a signal classification block 60. One way of identifying the types of modulation by name is by providing the different modulations that have been identified and located in the spectrum to a one dimensional CNN where they can be classified according to a list of known or expected modulations and allocated a corresponding name ($name_i$). Types of signal that are not recognised at this stage can be identified by a classification for 'unknown' signals.

In one embodiment, the classification according to a list of known or expected modulations can be based on a list that is updated by machine learning as will be discussed below. In a simpler system, though, the list can be pre-established and fixed.

Using this spectrum characterisation by fragmenting the spectrum and identifying the location (by carrier frequency and bandwidth) and, preferably, type of the different modulations present, allows for a user or system to understand the environment and how the spectrum is used, on a real time basis and this information can then be used for DSA and/or to understand how unknown environments are being used e.g. for military use. The fragmentation and characterisation allows information to be obtained from both known and unknown environments. Previous systems have relied on a previous study and understanding of the environment and isolation of modulations based on a previous understanding of the environment. The usefulness of these previous systems is therefore limited to static environments and their reliability is sensitive to noise fluctuations.

In the example shown in Figs. 1 and 3, the spectrum is in the radio frequency, RF, range. Communications typically take place in the RF spectrum. Recent technological developments, however, have made it more possible to use the microwave spectrum. Until recently, this spectrum has not been of interest in this field due to the lack of sufficient computational power and the complexity of programmability in photonics devices. Recently developed programmable integrated photonics (PIP) processors open the door to characterisation and classification of microwave spectra.

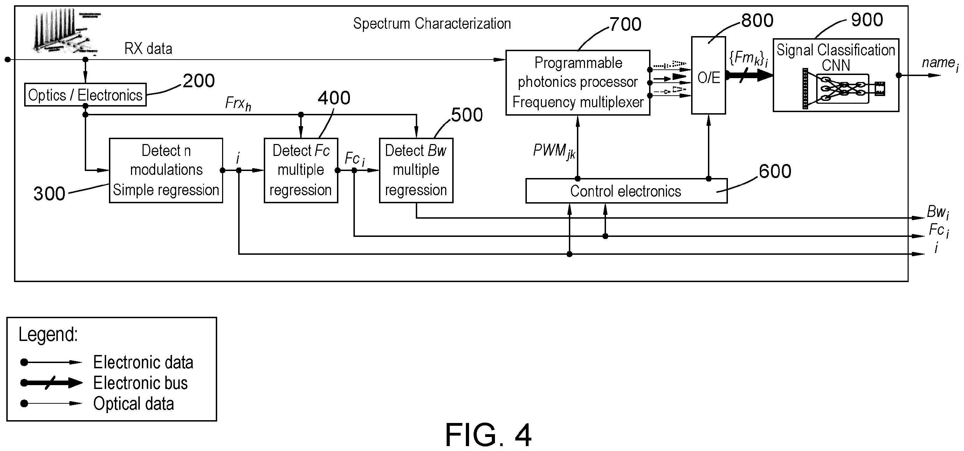

In one example according to the disclosure, therefore, the above-described spectrum characterisation concept can be modified to extend to the microwave spectrum. An example of architecture for spectrum characterisation for microwave photonics sensing is shown in Fig. 4.

The spectrum is converted to a signal that can be processed by regression blocks such as described above, in relation to Fig. 3, by optical circuitry 200 that provides the spectrum to fragmentation blocks 300, 400 and 500 to, respectively, obtain, using machine learning, the number of modulations $i$, the carrier frequency $Fc$ and the bandwidth $Bw$, essentially as described above. Control electronics 600 provides a matrix of electrical signals $PWM_{jk}$, to the PIP processor 700. The PIP processor is configured to serve as a frequency multiplexer, in place of the modulation fragmentation block 50 of Fig. 3 so that the information from the microwave spectrum can be received directly in the optical domain. The PIP processor contains a structure of programmable ring resonators that can be configured to filter and reroute a specific programmable frequency. The control electronics 600 configures its output signals $PWM_{jk}$, based on the determined number of modulations, carrier frequency and bandwidth, to program the optical filters of the PIP to properly isolate each modulation. The outputs of the PIP are then converted to the electronic domain 800 and can then be classified by type ($name_i$) in classification block 900 in a manner similar to Fig. 3.

A first aspect of the invention of this disclosure provides spectrum characterisation by fragmentation to provide information on the utilization of the spectrum in readable form in terms of the number of modulations, their location in the spectrum and, preferably, the type of modulation. This in itself provides a range of advantages over the prior art, as discussed above.

To further improve the usefulness of the information obtained about the spectrum, the output of the spectrum characterisation block 2 may be further subjected to a time analysis (block 3). The time analysis block 3 takes the signal classification information and analyses it in the time domain to identify temporal features of each type of modulation according to a set of rules. Such temporal features may be e.g. periodicity or frequency hopping. The time analysis block 3 outputs the time domain information in an interpretable manner, thus improving the explainability of the system (important for e.g. certification in avionics). Information provided in this manner can also be embedded in SDR devices which improves the speed of DSA.

One way of performing the time analysis uses stream reasoning - i.e. an incremental reasoning over streams of incrementally available information. Stream reasoning allows the analysis of rapidly changing information to detect patterns or trends in the data. Stream reasoning engines per se are known which can be used in the time analysis block 3. Rules can be set to e.g. analyse how many times a specific modulation has been detected, which modulations are hopping their carrier frequency and at what periodicity etc.

As described above, using the time analysed spectrum information and the fragmented modulation information, a processor (SDR brain 4) is able to make a determination as to the most appropriate type of modulation to use for the information to be transmitted.

Whilst advantageous in its own right, the spectrum characterisation technique also has application in the context of allocation of spectrum space to new signals to be transmitted in a system such as shown, for example, in Fig. 1.

Here, the information obtained from the system characterisation is processed to determine a selected modulation for use by a signal to be transmitted based on the spectrum characterisation - i.e. how the spectrum is currently being used.

The spectrum characterisation can be used by a learning block 5 to determine where in the spectrum available space exists or is likely to exist, so that signals to be transmitted can be allocated to such spaces and transmitted using a selected type of modulation.

The learning block 5 obtains frequency information - i.e. the selected modulation - of the signal to be transmitted and also obtains information, in the frequency domain, about the current use of the spectrum and makes a decision, using Reinforcement Learning (RL) techniques, to introduce the signal to be transmitted into the spectrum at the best carrier frequency and bandwidth available.

The RL learning block 5 trains on an artificial and controlled environment which uses information from signal characterisation, identifying the carrier frequencies and bandwidths being used in the spectrum, and, once trained, is able to identify the optimal carrier frequency and bandwidth for a new signal to be transmitted, that minimises inter-signal interference while maximising the bit rate transmission of the new signal. In one example, the RL block 5 uses the outputs from each of the blocks 20, 30, 40 of Fig. 3, or 300, 400, 500 of Fig. 4 independently to update its learning algorithm for determining the best available part of the spectrum for transmission of the new signal.

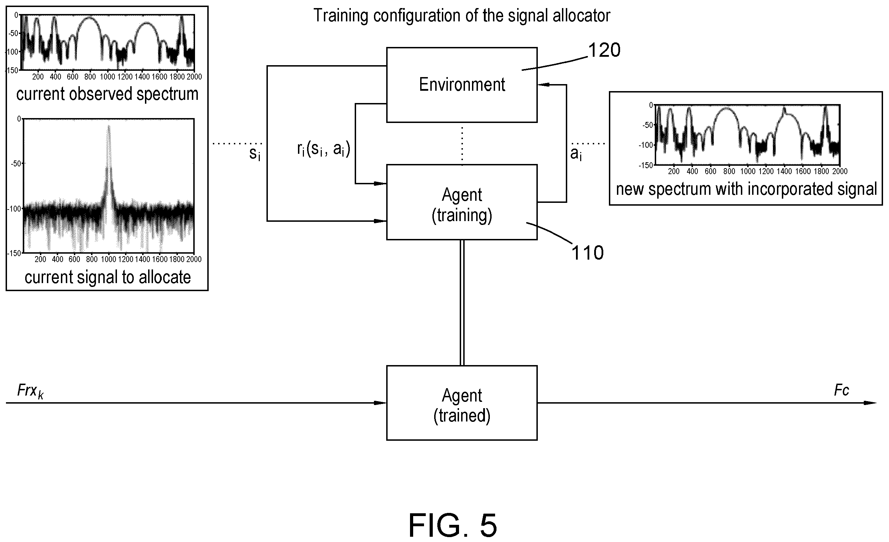

The training of the block is illustrated in Fig. 5 using a classic Markov Decision Process. An iterative training process takes place between the training agent 110 (which is the machine learning model chosen for the task) and the environment 120. The way the learning process works is that the agent 110 receives a state from the environment 120 in the form of an array that describes the current situation inside the environment. The array ($s_i$) includes data from the analysed spectrum and also from the new information to be transmitted. This may be from a simulation of the expected environment or may be based on input from the spectrum characterisation block 2 as described above. In response, the agent takes an action within the range of its available action space based on the current state from the environment and the model's prior knowledge acquired during previous iterations. The 'action' ($a_i$) is the suggested carrier frequency and bandwidth for the new signal. In this way, the model's 'knowledge' on which each action is based is constantly being updated to reflect changes in the environment.

The environment reacts to the received action which results in a new state to be use for the next iteration and also provides a 'reward metric' for the current iteration. The reward ($r_i$) is a metric of the interference produced between the original spectrum and the new modulation in the frequency suggested by the action.

The agent receives the 'reward' and interprets this as an indication of how successful the suggested action was. Based on this, the agent is also able to train itself and update its current knowledge.

One way of providing the reward function uses the 'Hadamard' product as discussed in R. A. Horn, 'The hadamard product,' Proc. Symp. Appl. Math, 1990. The interference ($\Delta W$) is calculated using the Hadamard product between the original spectrum and the newly allocated modulation in the selected carrier frequency. The latter assumes a Guassian noise wavelength in the rest of the spectrum. To compute the reward based on the observed interference, the signal is swept through the whole spectrum, checking interference in every possible position, to obtain the maximum ($\Delta W_{max}$) and minimum ($\Delta W_{min}$) possible interferences. The observed interference ($\Delta W_{observed}$) is used to obtain the reward function:

$$R(s,a) = \frac{\Delta Wmax - \Delta Wobserved}{\Delta Wmax - \Delta Wmin}$$

Using this technique allows for a faster response time from the environment when measuring the interference resulting in a shorter training time than in conventional approaches.

In this example, each learning iteration is considered to be independent from each other, usually referred to in the literature as "episodic tasks". Because this entails only considering immediate rewards, the value function that results from following a policy $\pi$ is given by the following simplification of the Bellman equation, which associates the policy $\pi$ to the probability of reaching the reward $r$ following the action a. Note that in this version, it only considers the immediate reward, discarding previous states, which allow us the number of training cycles to be reduced compared with the q-learning approach used in the SoTA.

$$V\pi(s) = \Sigma\pi(a|s)\cdot Praa(r(s,a))$$

The action space for the proposed RL model is technically continuous since frequency is a continuous parameter from an analog point of view. Following this assumption, actor-critic methods might be the most successful model for the task, given their advantage over continuous action spaces. However, since the observed state is already not represented as a continuous shape (it includes information from the new modulation as well as the original spectrum), we can simply discretize the available RF range, making it more compatible with most RL models, but maintaining the continuous nature of the spectrum. Under these conditions, a contextual bandit model would be a more suitable model for the task, since it not only benefits from the discrete action space but also the episodic nature of the task.

This allow the best carrier frequency and bandwidth to be selected without defining previous discrete channels as is known in the art.

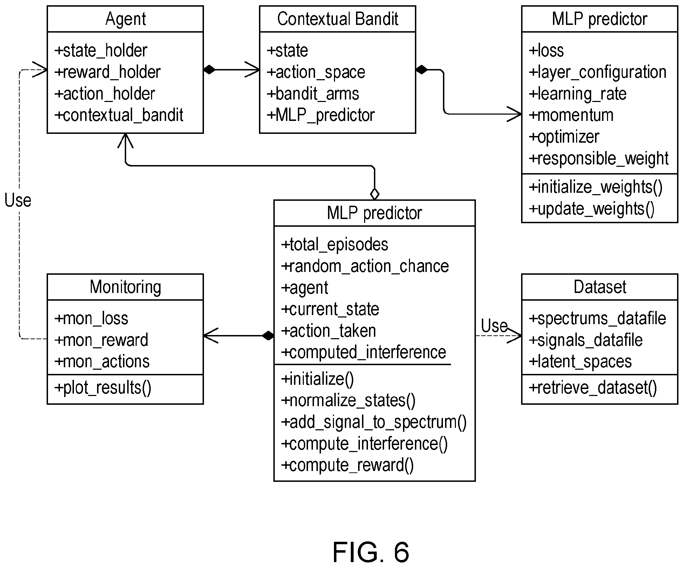

Figure 6 is a UML diagram showing how the above described components for the RL technique can be constructed and how they can interact with each other in an object oriented software implementation using Contextual Bandits, as an example. Those skilled in the art will be aware of other suitable constructions.

Using the concepts of this disclosure, communication in busy spectrums can be improved in terms of reliability and speed, and interference can be minimised between devices sharing the same bandwidth. The system can adapt dynamically to changing environments and newly introduced modulations allowing for increased safety and reliability. In providing explainable or readable outputs throughout the system, the system is suitable for certified use in many applications e.g. avionics and other safety-critical applications. The concept allows for an optimal use of available spectrums thus enabling communication of increased amounts of data.

Variations of the examples described above are possible within the scope of the invention as defined by the claims.

**Claims**

1. A method of analysing a spectrum on which information is transmitted, comprising:

   determining each different type of modulation used for transmitting the information across the spectrum,
   for each determined modulation, identifying its carrier frequency and its bandwidth,
   defining characteristics of usage of the spectrum in terms of the determined modulations and their corresponding carrier frequencies and bandwidths.

2. The method of claim 1, further comprising, for each determined modulation, identifying a name of the type of modulation, wherein the characteristics of usage of the spectrum are defined in terms of the determined modulations, the corresponding carrier frequencies and bandwidths and the name.

3. The method of claim 1 or 2, further comprising performing a time analysis on the determined types of modulation to determine time-related factors of the occurrence of each type of modulation.

4. The method of claim 4, wherein the time analysis is performed using a stream reasoning engine.

5. The method of any preceding claim, wherein the step of determining each different type of modulation used on the spectrum includes providing a frequency representation of the spectrum to a machine learning based model.

6. The method of claim 5, wherein the machine learning based model applies a regression calculation to the frequency representation of the spectrum to identify the different modulations.

7. The method of claim 5 or 6, wherein the machine learning based model applies a multivariate regression calculation to the frequency representation of the spectrum to identify the respective carrier frequencies.

8. The method of claim 5, 6 or 7, wherein the machine learning based model applies a multivariate regression calculation to the frequency representation of the spectrum to identify the respective bandwidths.

9. The method of claim 2 or any claim dependent thereon, wherein the step of identifying a name or the type of modulation comprises applying a one-dimensional CNN.

10. The method of any preceding claim, wherein the spectrum is in the radio frequency range.

11. The method of any of claims 1 to 9, wherein the spectrum is in the microwave range, wherein the analysis is performed using a programmable integrated photonics, PIP, processor.

12. A system for analysing a spectrum on which information is transmitted, the system including a first module (20) configured to determine the number of modulations used to transmit information on the spectrum, a second module (30) configured to determine the carrier frequency of each modulation determined by the first module, a third module (40) configured to determine the bandwidth of each modulation determined by the second module, and a fourth module (50) to provide a spectrum characterisation in terms of the number of modulations and their carrier frequencies and bandwidths.

13. The system of claim 12, further comprising a signal classification module (60) to associate each determined modulation with a modulation type name.

14. The system of claim 12 or 13, further comprising a time analysis module (3) to perform a time analysis on the modulations identified by the first module.

15. The system of any of claims 12 to 14, wherein the spectrum is in the microwave range, the system comprising a programmable integrated photonics, PIP, processor (700) for frequency multiplexing of the spectrum.

FIG. 1

EP 4 145 144 A1

FIG. 2

FIG. 3

FIG. 4

EP 4 145 144 A1

Training configuration of the signal allocator

current observed spectrum

current signal to allocate

$s_i$

$r_i(s_i, a_i)$

Environment

120

$a_i$

Agent
(training)

110

new spectrum with incorporated signal

$Frx_k$

Agent
(trained)

$Fc$

FIG. 5

EP 4 145 144 A1

**Agent**

+state_holder
+reward_holder
+action_holder
+contextual_bandit

**Contextual Bandit**

+state
+action_space
+bandit_arms
+MLP_predictor

**MLP predictor**

+loss
+layer_configuration
+learning_rate
+momentum
+optimizer
+responsible_weight

+initialize_weights()
+update_weights()

**MLP predictor**

+total_episodes
+random_action_chance
+agent
+current_state
+action_taken
+computed_interference

+initialize()
+normalize_states()
+add_signal_to_spectrum()
+compute_interference()
+compute_reward()

**Monitoring**

+mon_loss
+mon_reward
+mon_actions

+plot_results()

Use

**Dataset**

+spectrums_datafile
+signals_datafile
+latent_spaces

+retrieve_dataset()

Use

## FIG. 6

Europäisches
Patentamt

European
Patent Office

Office européen
des brevets

**EUROPEAN SEARCH REPORT**

Application Number

**EP 21 19 4972**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/144831 A1 (DGS GLOBAL SYSTEMS INC [US]) 18 September 2014 (2014-09-18)<br>* paragraph [0003] *<br>* paragraph [0042] *<br>* paragraph [0085] *<br>* paragraph [0093] *<br>----- | 1-15 | INV.<br>G01R23/16<br>H04L1/00<br>H04L27/00 |
| X | JAJOO GAURAV ET AL: "Implementation of modulation classifier over software defined radio",<br>IET COMMUNICATIONS, THE INSTITUTION OF ENGINEERING AND TECHNOLOGY, GB,<br>vol. 14, no. 9, 2 June 2020 (2020-06-02), pages 1467-1475, XP006090315,<br>ISSN: 1751-8628, DOI: 10.1049/IET-COM.2019.0922<br>* abstract *<br>----- | 1-15 | |
| X | US 2017/250766 A1 (DZIERWA RONALD C [US] ET AL) 31 August 2017 (2017-08-31)<br>* paragraph [0082] *<br>* paragraph [0088] – paragraph [0090] *<br>----- | 1-15 | |
| | | | TECHNICAL FIELDS SEARCHED (IPC)<br><br>G01R<br>H04L |

The present search report has been drawn up for all claims

| Place of search | Date of completion of the search | Examiner |
|---|---|---|
| The Hague | 28 February 2022 | Colzi, Enrico |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 21 19 4972**

This annex lists the patent family members relating to the patent documents cited in the above-mentioned European search report.
The members are as contained in the European Patent Office EDP file on
The European Patent Office is in no way liable for these particulars which are merely given for the purpose of information.

**28-02-2022**

| Patent document cited in search report | | Publication date | Patent family member(s) | | Publication date |
|---|---|---|---|---|---|
| WO 2014144831 | A1 | 18-09-2014 | NONE | | |
| US 2017250766 | A1 | 31-08-2017 | US | 2017250766 A1 | 31-08-2017 |
| | | | US | 2019208491 A1 | 04-07-2019 |
| | | | US | 2020196269 A1 | 18-06-2020 |
| | | | US | 2022030541 A1 | 27-01-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **H. SONG ; L. LIU ; J. ASHDOWN ; Y. YI.** A Deep Reinforcement Learning Framework for Spectrum Management in Dynamic Spectrum Access. *IEEE Internet of Things Journal*
- **Y. XU ; J. YU ; W.C. HEADLEY ; R.M. BUEHRER.** Deep Reinforcement Learning for Dynamic Spectrum Access in Wireless Networks. *MILCOM 2018 - 2018 IEEE Military Communications Conference, (MILCOM), Los Angeles, CA, USA,* 2018, 207-212
- **O. NAPARSTEK ; K. COHEN.** Deep Multi-User Reinforcement Learning for Distributed Dynamic Spectrum Access. *IEEE Transactions on Wireless Communications,* January 2019, vol. 18 (1), 310-323

- **G. HONG ; J. MARTIN ; J. WESTALL.** Adaptive bandwidth binning for bandwidth management. Elsevier, 2019
- **H. CHANG ; H. SONG ; Y. YI ; J. ZHANG ; H. HE ; L. LIU.** Distributive Dynamic Spectrum Access Through Deep Reinforcement Learning: A Reservoir Computing-Based Approach. *IEEE Internet of Things Journal,* April 2019, vol. 6 (2), 1938-1948
- **R. A. HORN.** The hadamard product. *Proc. Symp. Appl. Math,* 1990